# EUROPÄISCHE PATENTSCHRIFT

(11) **EP 2 215 386 B1**
(45) Veröffentlichungstag und Bekanntmachung des Hinweises auf die Patenterteilung: **11.12.2013**
(21) Anmeldenummer: 08856720.1
(22) Anmeldetag: 22.10.2008
(51) Int. Cl.: C23C 16/27, F16J 15/00, F16J 15/34

(54) **GLEITRING EINER GLEITRINGDICHTUNGSANORDNUNG**
SLIP RING OF AN AXIAL FACE SEAL ARRANGEMENT
ANNEAU DE GLISSEMENT D'UNE GARNITURE MÉCANIQUE D'ÉTANCHÉITÉ

(30) Priorität: 04.12.2007 DE 202007016868 U
(43) Veröffentlichungstag der Anmeldung: 11.08.2010
(73) Patentinhaber: EagleBurgmann Germany GmbH & Co. KG, 82515 Wolfratshausen (DE)
(72) Erfinder: OTSCHIK, Joachim, 63741 Aschaffenburg (DE); SCHRÜFER, Andreas, 82515 Wolfratshausen (DE); SCHICKTANZ, Rudolf, 82538 Geretsried (DE); KIRCHHOF, Martin, 81477 München (DE)
(74) Vertreter: Schaeberle, Steffen
(86) Internationale Anmeldenummer: PCT/EP2008/008937
(87) Internationale Veröffentlichungsnummer: WO 2009/071154

(56) Entgegenhaltungen:
- DE-A1- 19 922 665
- JP-A- 4 238 884

## Beschreibung

Die Erfindung betrifft einen Gleitring einer Gleitringdichtungsanordnung der im Oberbegriff des Anspruchs 1 genannten Art.

Aus der DE 20 2006 006 425 U ist bereits ein Gleitring einer Gleitringdichtung bekannt, dessen Basiskörper aus einem SiC Material gebildet ist, wobei eine Stirnseite des Basiskörpers von einer Schicht aus einem Diamantmaterial bedeckt ist. Die Druckschrift erwähnt ferner, dass Diamantbeschichtungen nach dem sog. CVD-Abscheidungsverfahren (Hot Filament Chemical Vapour Deposition-Verfahren) direkt auf der betreffenden Stirnfläche in situ aufgebracht sein können. Bei diesem Vorgang werde der Basiskörper hohen thermischen Belastungen ausgesetzt. Dreidimensionale Körper, bei denen es sich um Gleitringe handeln kann, aus keramischen Materialien wie SiC mit feinkristallinen Diamantbeschichtungen sind ferner aus der DE 199 22 665 A bekannt. Der Druckschrift sind ferner nähere Informationen zum CVD-Abscheidungsverfahren und den damit verbundenen Parametern zu entnehmen.

Gemeinsam ist den bekannten Gleitringen der vorgenannten Art, dass die Diamantbeschichtungen zwar eine natürliche hohe Festigkeit gegen thermisch induzierte Wärmespannungen aufweisen und daher bei Betrieb ohne Weiteres hohen Temperaturen und raschen Temperaturwechseln bei gleichzeitig hohen mechanischen Beanspruchungen ausgesetzt werden können, ohne dass innere Brüche oder Risse in der Diamantbeschichtung auftreten. Die Praxis hat jedoch gezeigt, dass das karbidische Material, insbesondere SiC, des Basiskörpers unter solchen Betriebsbedingungen wesentlich empfindlicher reagiert. Es können daher unter der Diamantbeschichtung im Basiskörper Risse und Brüche auftreten, wodurch nicht nur der innere Zusammenhalt des Basiskörpers in mehr oder minder grossem Umfang gestört wird, sondern es auch zu lokalen Ablöseerscheinungen zwischen Basiskörper und Diamantbeschichtung kommen kann. Trotz an sich weiterhin intakten Diamantbeschichtungen erfordert das Auftreten von Rissen oder Brüchen im Basiskörper einen sofortigen Austausch der Gleitringe. Andererseits stellen diese ein grundsätzlich besonders teures Bauteil dar.

Angesichts dieser mit bekannten diamantbeschichteten Basiskörpern aus einem karbidischen Material verbundenen Probleme liegt der Erfindung die Aufgabe zugrunde, einen Gleitring der gattungsgemässen Art zu schaffen, der eine verbesserte Betriebszuverlässigkeit bei hohen, insbesondere rasch wechselnden Temperaturen und/oder mechanischen Beanspruchungen aufweisen soll.

Diese Aufgabe wird durch die Merkmale des Anspruches 1 gelöst.

Erfindungsgemäss besteht der Basiskörper anders als bei den bekannten Gleitringanordnungen aus einem Zweikomponentenmaterial. Dieses umfasst einerseits wenigstens ein karbidisches Material wie SiC oder WC, ggf. zusammen mit eingelagertem Si- bzw. Ni- Anteilen zwischen den einzelnen Karbid-Körnern, und partikuläre über den Querschnitt des Basiskörpers verteilte Bereiche oder Körner aus einem geeigneten Diamantmaterial. Dieses Diamantmaterial entspricht vorzugsweise demjenigen, aus dem die Beschichtung besteht. Es kann sich auch davon unterscheiden, vorausgesetzt es liegt chemisch-physikalisch-strukurelle Verträglichkeit zwischen den Diamantmaterialien vor. Es wurde festgestellt, dass die Diamantpartikel oder -körner im Basiskörper einen Volumenanteil zwischen 10 bis 90 % einnehmen sollten.

Der erfindungsgemässe Zweikomponenten-Basiskörper zeichnet sich durch eine wesentlich erhöhte Riss- und Bruchfestigkeit unter inneren durch thermische oder mechanische Beanspruchungen hervorgerufenen Spannungen aus. Insbesondere erweist sich die Verbindung zwischen dem Diamantmaterial der Beschichtung und dem Basiskörper deutlich stabiler, da die Diamantbeschichtung quasi eine feste Verankerung an den Diamantkörnern des Basiskörpers erhält. Darüber hinaus hat der Umstand, dass das Diamantmaterial eine wesentlich höhere Wärmeleitfähigkeit als SiC oder WC hat, zur Folge, dass die Ableitung von Wärme an die Umgebung gefördert wird, so dass innere Wärmestauzonen entweder nicht auftreten oder in kurzer Zeit abgebaut werden können. Ein weiterer Vorteil aus dem Vorsehen eines Basiskörpers aus dem Zweikomponentenmaterial ist eine erhöhte Abriebfestigkeit an den Oberflächenbereichen des Basiskörpers, die nicht durch die Diamantbeschichtung gegen Abrieb geschützt sind.

Die Diamantmaterialpartikel im Basiskörper sollten eine Korngrösse im Bereich von 0,01 bis 1,0 mm haben, wobei eine Korngrösse von 0,02 bis 0,2 mm bevorzugt wird. Im allgemeinen haben die Diamantmaterialpartikel eine unregelmässige räumliche Umrisskonfiguration. Unter dem Begriff "Korngrösse" ist daher die Abmessung an der Stelle eines unregelmässigen Kornes zu verstehen, bei dem eine maximale diametrale Abmessung vorliegt. Die Verteilung der Diamantpartikel im Basiskörper kann gleichmässig sein, oder sie ist, wenn erwünscht, ungleichmässig, indem z.B. eine erhöhte Konzentration von Diamantpartikeln an Querschnittsbereichen nahe der Diamantbeschichtung vorliegen kann.

Wie schon erwännt wurde, sollte der Anteil des Diamantmaterials im Zweikomponentenmaterial zwischen 10 und 90 Vol-% betragen. Vorzugsweise beträgt der Anteil zwischen 40 und 70 Vol-%, wobei ein Anteil zwischen 50 und 60 Vol-% besonders bevorzugt wird. Es wurde auch schon darauf hingewiesen, dass der Siliciumanteil im Basiskörper sowohl durch überwiegendes SiC (Siliziumkarbid) gebildet sein kann, als auch SiC in Verbindung mit Si (Silizium) umfassen kann. Bei WC (Wolframkarbid) als karbidisches Material kann neben WC in Reinform diesem auch ein Anteil von z.B. 6 Vol % Ni (Nickel) zugegeben sein.

Ein bevorzugtes Verfahren zur Herstellung des efindungsgemässen Zweikomponenten-Basiskörpers besteht darin, das karbidische Material und Diamantmaterial, beide in Form loser Partikel, miteinander zu vermischen und anschliessend durch Sintern zu einem festen Verbund zu formen. Geeignete Sinterverfahren sind dem Fachmann bekannt, so dass diesbezüglich keine näheren Erläuterungen erforderlich sind.

Im Anschluss an die Bildung des Zweikomponenten-Basiskörpers kann auf diesem die Diamantbeschichtung nach einem der geeigneten Diamantabscheidungsverfahren in situ aufgegeben werden. Die freie Oberfläche der Diamantbeschichtung schafft eine Gleit- oder Dichtfläche mit hoher Abriebfestigkeit und zeichnet sich ferner durch hohe thermische, mechanische und chemische Beständigkeit aus. Bevorzugt kommen das sog. Hot Filament CVD- oder Plasma-CVD-Verfahren zum Einsatz. Diese Verfahren sind dem Fachmann mit allen einschlägigen Verfahrens-parametern und einzuhaltenden Konditionen bekannt und brauchen an dieser Stelle daher nicht näher erläutert zu werden. Grundzüge des Hot Filament CVD-Verfahrens sind z.B. zu entnehmen aus Busmann, H.-G., Hertel, I.V., Vapor Grown Polycristalline Diamond Films, Carbon 36(4), 1998. Verfahrenshinweise zum Hot Filament CVD-Verfahren sind ferner in der schon eingangs erwähnten DE 199 22 665 B4 enthalten. Zum Plasma CVD-Verfahren kann z.B. verwiesen werden auf: Jones, G. A., On the behavior of mechanical seal face materials in dry line contact, Wear 256(3-4), 2004.

Erfindungsgemäss ausgebildete Gleitringe kommen bevorzugt bei Gleitringdichtungen zum Einsatz, die bei Betrieb hohen Temperaturen und Drücken ausgesetzt sind. Es können vorzugsweise beide Gleitringe der zusammenwirkenden Paarung in der erfindungsgemässen Weise ausgebildet sein, oder nur einer, während der andere Gleitring aus einem anderen geeigneten Material bestehen kann. Der grundsätzliche Aufbau einer Gleitringdichtung ist dem Fachmann bekannt und erfordert daher keine nähere Erläuterung.

## Patentansprüche

1. Gleitring einer Gleitringdichtungsanordnung, bestehend aus einem Basiskörper aus einem wenigstens ein karbidisches Material umfassenden Material und einer am Basiskörper vorgesehenen, eine Gleitfläche schaffenden Beschichtung aus einem Diamantmaterial, **dadurch gekennzeichnet, dass** der Basiskörper aus einem Zweikomponentenmaterial gebildet ist, indem in dem wenigstens ein karbidisches Material umfassenden Material partikuläre Bereiche aus einem mit dem Diamantmaterial der Beschichtung verträglichen Diamantmaterial eingebettet sind.

2. Gleitring nach Anspruch 1, **dadurch gekennzeichnet, dass** die Diamantmaterialien für die Beschichtung und den Basiskörper gleich oder unterschiedlich sind.

3. Gleitring nach Anspruch 1 oder 2, **dadurch gekennzeichnet, dass** die partikulären Bereiche aus Diamantmaterial eine Korngrösse im Bereich von 0,01 bis 1,0 mm, vorzugsweise von 0,02 bis 0,2 mm, haben.

4. Gleitring nach Anspruch 1, 2 oder 3, **dadurch gekennzeichnet, dass** der Anteil des Diamantmaterials im Zweikomponentenmaterial zwischen 10 bis 90 Vol-%, vorzugsweise zwischen 40 und 70 Vol-%, höchst vorzugsweise zwischen 50 und 60 Vol-% beträgt.

5. Gleitring nach einem der vorhergehenden Ansprüche, **dadurch gekennzeichnet, dass** der Basiskörper durch Sintern von partikulärem karbischen Material und Diamantmaterial gebildet ist.

6. Gleitring nach einem der vorhergehenden Ansprüche, **dadurch gekennzeichnet, dass** das karbidische Material ein solches aus der Gruppe SiC und WC umfassenden Materialien ist.

## Claims

1. A seal ring of a mechanical seal assembly, comprising: a base body made of a material including at least one carbide material, and a coating provided at the base body and creating a sliding surface, said coating consisting of a diamond material, **characterized in that** the base body is formed of a two-component material by embedding particulate regions made of a diamond material compatible with the diamond material of the coating into the material comprising at least one carbide material.

2. The seal ring of claim 1, **characterized in that** the diamond materials for the coating and the base body are either identical or different.

3. The seal ring of claim 1 or 2, **characterized in that** the particulate regions made of diamond material have a grain size in the range of 0.01 to 1.0 mm, preferably 0.02 to 0.2 mm.

4. The seal ring of claim 1, 2 or 3, **characterized in that** the proportion of the diamond material in the two-component material ranges between 10 to 90% by volume, preferably between 40 to 70% by volume, most preferably between 50 to 60% by volume.

5. The seal ring of any of the preceding claims, **characterized in that** the base body is formed by sintering particulate carbide material and diamond material.

6. The seal ring of any of the preceding claims, **characterized in that** the carbide material is one of the group of materials comprising SiC and WC.

## Revendications

1. Anneau de glissement d'une garniture mécanique d'étanchéité, constitué d'un corps de base en un matériau comprenant au moins un carbure et d'un revêtement en un matériau à base de diamant, prévu sur le corps de base et créant une surface de glissement, **caractérisé en ce que** le corps de base est constitué d'un matériau à deux composants, par le fait que des zones particulaires constituées d'un matériau à base de diamant compatible avec le matériau à base de diamant du revêtement sont incorporées dans le matériau comprenant au moins un carbure.

2. Anneau de glissement selon la revendication 1, **caractérisé en ce que** les matériaux à base de diamant pour le revêtement et pour le corps de base sont identiques ou différents.

3. Anneau de glissement selon la revendication 1 ou 2, **caractérisé en ce que** les zones particulaires constituées de matériau à base de diamant ont une grosseur de grain dans la plage de 0,01 à 1,0 mm, de préférence de 0,02 à 0,2 mm.

4. Anneau de glissement selon la revendication 1, 2 ou 3, **caractérisé en ce que** la part de matériau à base de diamant dans le matériau à deux composants est comprise entre 10 et 90 % en volume, de préférence entre 40 et 70 % en volume, d'une manière la plus préférée entre 50 et 60 % en volume.

5. Anneau de glissement selon l'une des revendications précédentes, **caractérisé en ce que** le corps de base est formé par frittage de carbure particulaire et de matériau à base de diamant particulaire.

6. Anneau de glissement selon l'une des revendications précédentes, **caractérisé en ce que** le carbure est un carbure du groupe de matériaux comprenant le carbure de silicium (SiC) et le carbure de tungstène (WC).
